# EUROPEAN PATENT APPLICATION

(11) **EP 2 439 802 A1**
(43) Date of publication of application: **11.04.2012**
(21) Application number: 10783231.3
(22) Date of filing: 11.05.2010
(51) Int. Cl.: H01L 51/30, C08G 61/12, H01L 21/336, H01L 29/786, H01L 29/80, H01L 51/05, H01L 51/40, H01L 51/50

(54) **ORGANIC THIN FILM TRANSISTOR, SURFACE LIGHT SOURCE AND DISPLAY DEVICE**

(30) Priority: 03.06.2009 JP 2009134177
(71) Applicant: Sumitomo Chemical Company, Limited, Tokyo 104-8260 (JP); National University of Corporation Hiroshima University, Higashihiroshima-shi Hiroshima 739-8511 (JP)
(72) Inventor: TAKIMIYA Kazuo, Higashihiroshima-shi Hiroshima 739-8527 (JP); KOHIRO Kenji, Tsukuba-shi Ibaraki 305-0032 (JP); TERAI Hiroki, Tsukuba-shi Ibaraki 3050005 (JP)
(74) Representative: Duckworth, Timothy John
(86) International application number: PCT/JP2010/057960
(87) International publication number: WO 2010/140447

(57) **Abstract**

An organic thin-film transistor of the invention comprises an organic semiconductor layer that contains a polymer compound having a repeating unit represented by the following formula (1) and/or a repeating unit represented by the following formula (2), and a repeating unit represented by the following formula (3).

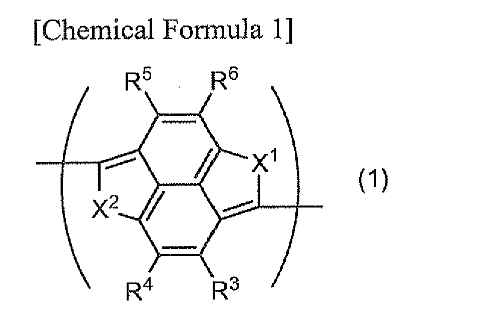

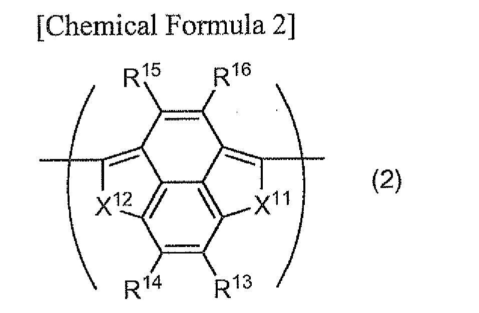

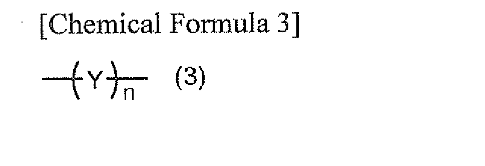

## Description

### Technical Field

The present invention relates to an organic thin-film transistor, a surface light source and a display device.

### Background Art

Organic transistors having a semiconductor layer composed of an organic material that functions as a carrier transport layer (organic thin-film transistors) can be manufactured at low cost, while their circuits are flexible allowing them to be folded, and they have therefore been of great interest in recent years for their suitability for electronic paper and flexible displays, for example. Organic semiconductor materials are used as the organic materials composing such semiconductor layers (organic semiconductor layers).

Because organic semiconductor materials can simplify the production process, polymer compounds are being studied that can form organic semiconductor layers by dissolving such materials in solvents and coating them. One example of such a polymer compound that has been proposed is a polymer compound composed of an alternating copolymer of fluorene and bithiophene (see Non-patent document 1).

### [Citation List]

### Non-Patent Literature

[Non-patent document 1] APPLIED PHYSICS LETTERS, Vol.77, No.3, 2000, p.406-408

### Summary of Invention

### Technical Problem

The characteristics of an organic thin-film transistor depend primarily on the mobility of charge (electrons or holes) in the organic semiconductor layer, and a higher charge mobility corresponds to improved field-effect mobility and superior characteristics of the organic thin-film transistor. With the widening variety of uses for organic thin-film transistors in recent years, there is a demand for higher charge mobility than can be conventionally achieved. However, it has been difficult to satisfactorily obtain the high mobility demanded in recent years when using the aforementioned conventional polymer compounds.

In light of these circumstances, it is an object of the present invention to discover polymer compounds that allow high charge mobility to be obtained when they are used in organic semiconductor layers of organic thin-film transistors, and to provide organic thin-film transistors that employ the polymer compounds to obtain excellent field-effect mobility. It is another object of the invention to provide a surface light source and display device comprising the organic thin-film transistor.

### Solution to Problem

In order to achieve the objects stated above, the invention provides an organic thin-film transistor comprising an organic semiconductor layer containing a polymer compound having a repeating unit represented by the following formula (1) and/or a repeating unit represented by the following formula (2), and a repeating unit represented by the following formula (3): 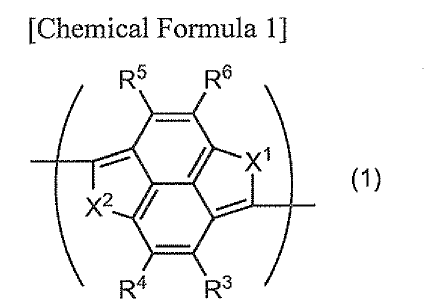 in formula (1), X¹ and X² are the same or different and each represents a chalcogen atom, and R³, R⁴, R⁵ and R⁶ are the same or different and each represents hydrogen atom, alkyl, alkoxy, alkylthio, optionally substituted aryl, aryloxy, arylthio, arylalkyl, arylalkoxy, arylalkylthio, substituted silyl, substituted carboxyl, an optionally substituted monovalent heterocyclic group, cyano or fluorine atom; 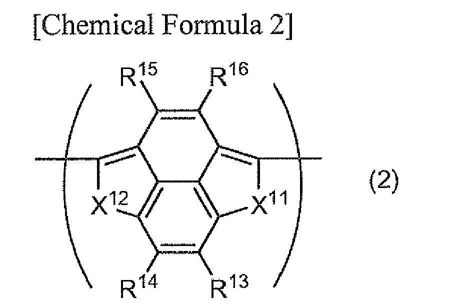 in formula (2), X¹¹ and X¹² are the same or different and each represents a chalcogen atom, and R¹³, R¹⁴, R¹⁵ and R¹⁶ are the same or different and each represents hydrogen atom, alkyl, alkoxy, alkylthio, optionally substituted aryl, aryloxy, arylthio, arylalkyl, arylalkoxy, arylalkylthio, substituted silyl, substituted carboxyl, an optionally substituted monovalent heterocyclic group, cyano or fluorine atom; 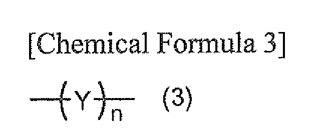 in formula (3), Y represents an arylene group comprising 3 or more fused aromatic rings that may be optionally substituted, an optionally substituted divalent heterocyclic group, an optionally substituted divalent group with a metal complex structure, or the group -C≡C-, and n represents an integer of 1-5; when there are a plurality of Y groups, the Y groups may be the same or different.

Since the polymer compound has a repeating unit represented by formula (1) and/or a repeating unit represented by formula (2), and a repeating unit represented by formula (3), high charge mobility can be obtained when it is used in the organic semiconductor layer of an organic thin-film transistor. In addition, because the organic thin-film transistor described above comprises an organic thin-film containing the polymer compound, it is possible to obtain excellent field-effect mobility.

In the organic thin-film transistor of the invention, at least one pair of R³ and R⁵ in formula (1), R⁴ and R⁶ in formula (1), R¹³ and R¹⁵ in formula (2), and R¹⁴ and R¹⁶ in formula (2), are preferably the same groups. This will further improve the charge mobility of the polymer compound, and will allow excellent field-effect mobility to be more easily obtained for the organic thin-film transistor.

In the organic thin-film transistor of the invention, preferably R³-R⁶ in formula (1) are hydrogen atoms and/or R¹³-R¹⁶ in formula (2) are hydrogen atoms. This will further improve the charge mobility of the polymer compound, and will allow excellent field-effect mobility to be more easily obtained for the organic thin-film transistor.

In the organic thin-film transistor of the invention, at least one of X¹ and X² in formula (1) and X¹¹ and X¹² in formula (2), is preferably a sulfur atom. This will further improve the charge mobility of the polymer compound, will allow excellent field-effect mobility to be more easily obtained for the organic thin-film transistor, and is also superior for the environment.

In the organic thin-film transistor of the invention, Y in formula (3) is preferably an optionally substituted divalent heterocyclic group. This will further improve the charge mobility of the polymer compound, and will allow excellent field-effect mobility to be more easily obtained for the organic thin-film transistor.

In the organic thin-film transistor of the invention, the repeating unit represented by formula (3) is preferably a repeating unit represented by the following formula (4). This will further improve the charge mobility of the polymer compound, and will allow excellent field-effect mobility to be more easily obtained for the organic thin-film transistor. In the repeating unit represented by the following formula (4), the two thiophene rings are rotatable around the axis of the single bond through which they are bonded. The repeating unit represented by formula (4), therefore, also includes repeating units with a configuration in which each thiophene ring has its sulfur atoms on the same side of the axis. 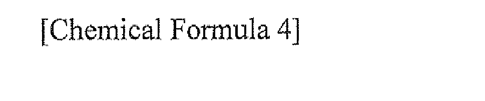 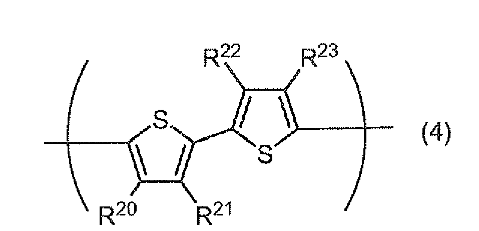 In formula (4), R²⁰, R²¹, R²² and R²³ are the same or different and each represents hydrogen atom, alkyl, alkoxy, alkylthio, optionally substituted aryl, aryloxy, arylalkyl, arylalkoxy, substituted silyl, carboxyl, an optionally substituted monovalent heterocyclic group, cyano or fluorine atom.

At least one among R²⁰, R²¹, R²² and R²³ in formula (4) is preferably a C6-20 alkyl group. This will result in a satisfactory balance between organic solvent solubility and heat resistance of the polymer compound.

The invention further provides a surface light source comprising the organic thin-film transistor of the invention.

The invention still further provides a display device comprising the organic thin-film transistor of the invention.

The surface light source and display device can exhibit excellent properties because they comprise the organic thin-film transistor of the invention, which has excellent field-effect mobility.

### Advantageous Effects of Invention

The polymer compound having the specific structure described above can exhibit high charge mobility when used in the organic semiconductor layer of an organic thin-film transistor. According to the invention, the polymer compound may be used to provide an organic thin-film transistor that allows excellent field-effect mobility to be obtained. Also, according to the invention, it is possible to provide a surface light source and display device comprising the organic thin-film transistor. The organic thin-film transistor of the invention is useful, for example, in a driving circuit of a liquid crystal display or electronic paper, in a switching circuit of a curved or flat light source used for illumination, in a segment type display device, or in a driving circuit for a dot matrix flat panel display.

### Brief Description of Drawings

Fig. 1 is a schematic cross-sectional view of an organic thin-film transistor according to a first embodiment.
Fig. 2 is a schematic cross-sectional view of an organic thin-film transistor according to a second embodiment.
Fig. 3 is a schematic cross-sectional view of an organic thin-film transistor according to a third embodiment.
Fig. 4 is a schematic cross-sectional view of an organic thin-film transistor according to a fourth embodiment.
Fig. 5 is a schematic cross-sectional view of an organic thin-film transistor according to a fifth embodiment.
Fig. 6 is a schematic cross-sectional view of an organic thin-film transistor according to a sixth embodiment.
Fig. 7 is a schematic cross-sectional view of an organic thin-film transistor according to a seventh embodiment.
Fig. 8 is a schematic cross-sectional view of a surface light source according to an embodiment.
Fig. 9 is a schematic cross-sectional view of an organic thin-film transistor fabricated in the examples.

### Description of Embodiments

The present invention will now be explained in detail based on its preferred embodiments. Throughout the present specification, "repeating unit" means a structural unit of which one or more is present in the polymer compound. The term "mono-/di-valent heterocyclic group" means a group derived by removing 1 or 2 hydrogen atoms from a heterocyclic compound (especially an aromatic heterocyclic compound). The term "heterocyclic compound" means an organic compound with a ring structure that also contains not only carbon atoms, but also a heteroatom such as an oxygen atom, sulfur atom, nitrogen atom, phosphorus atom or boron atom, as elements composing the ring.

### (Polymer compound)

The polymer compound used in the organic semiconductor layer of the organic thin-film transistor of the invention has a repeating unit represented by formula (1) and/or a repeating unit represented by formula (2), and a repeating unit represented by formula (3).

Groups X¹, X², X¹¹ and X¹² in formulas (1) and (2) may be the same or different, and represent chalcogen atoms.

Chalcogen atoms include oxygen, sulfur, selenium and tellurium atoms, with sulfur, selenium and tellurium atoms being preferred from the viewpoint of satisfactory charge mobility, and sulfur atoms being preferred from environmental considerations.

In formulas (1) and (2), R³₋R⁶ and R¹³-R¹⁶ are the same or different and each represents hydrogen atom, alkyl, alkoxy, alkylthio, optionally substituted aryl, aryloxy, arylthio, arylalkyl, arylalkoxy, arylalkylthio, substituted silyl, substituted carboxyl, an optionally substituted monovalent heterocyclic group, cyano or fluorine atom.

The alkyl groups may be straight-chain, branched or cyclic, with preferably 1-24, more preferably 6-22 and even more preferably 8-18 carbon atoms. Specific examples of alkyl groups include methyl, ethyl, propyl, i-propyl, butyl, i-butyl, t-butyl, pentyl, isoamyl, hexyl, cyclohexyl, heptyl, octyl, 2-ethylhexyl, nonyl, decyl, 3,7-dimethyloctyl, undecyl, dodecyl, tetradecyl, hexadodecyl, octadodecyl, trifluoromethyl, pentafluoroethyl, perfluorobutyl, perfluorohexyl and perfluorooctyl. Preferred among these are methyl, ethyl, propyl, i-propyl, butyl, i-butyl, t-butyl, pentyl, isoamyl, hexyl, octyl, 2-ethylhexyl, decyl, 3,7-dimethyloctyl, undecyl, dodecyl, tetradecyl, hexadodecyl and octadodecyl, from the viewpoint of satisfactory balance between solubility in organic solvents and heat resistance of the polymer compound.

The alkoxy groups may be straight-chain, branched or cyclic, with preferably 1-24 and more preferably 6-22 carbon atoms. Specific examples of alkoxy groups include methoxy, ethoxy, propyloxy, i-propyloxy, butoxy, i-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, undecyloxy, dodecyloxy, tetradecyloxy, hexadecyloxy, octadecyloxy, trifluoromethoxy, pentafluoroethoxy, perfluorobutoxy, perfluorohexyl, perfluorooctyl, methoxymethyloxy, 2-methoxyethyloxy and 2-ethoxyethyloxy. Preferred among these are hexyloxy, octyloxy, 2-ethylhexyloxy, decyloxy, 3,7-dimethyloctyloxy, undecyloxy, dodecyloxy, tetradecyloxy, hexadecyloxy and octadecyloxy, from the viewpoint of satisfactory balance between solubility in organic solvents and heat resistance of the polymer compound.

The alkylthio groups may be straight-chain, branched or cyclic, with preferably 1-24 and more preferably 6-22 carbon atoms. Specific examples of alkylthio groups include methylthio, ethylthio, propylthio, i-propylthio, butylthio, i-butylthio, t-butylthio, pentylthio, hexylthio, cyclohexylthio, heptylthio, octylthio, 2-ethylhexylthio, nonylthio, decylthio, 3,7-dimethyloctylthio, undecylthio, dodecylthio, tetradecylthio, hexadecylthio, octadecylthio and trifluoromethylthio. Preferred among these are hexylthio, octylthio, 2-ethylhexylthio, decylthio, 3,7-dimethyloctylthio, undecylthio, dodecylthio, tetradecylthio, hexadecylthio and octadecylthio, from the viewpoint of satisfactory balance between solubility in organic solvents and heat resistance of the polymer compound.

An aryl group is an atomic group derived by removing one hydrogen atom from an aromatic hydrocarbon, and the term includes those with fused rings, and independent benzene rings or groups having two or more fused rings bonded directly or via a vinylene group. The number of carbon atoms of the aryl group is preferably 6-60, more preferably 6-48, even more preferably 6-20 and most preferably 6-10. Specific examples of aryl groups include phenyl, 1-naphthyl, 2-naphthyl, 1-anthracenyl, 2-anthracenyl, 9-anthracenyl, 1-tetracenyl, 2-tetracenyl, 5-tetracenyl, 1-pyrenyl, 2-pyrenyl, 4-pyrenyl, 2-perylenyl, 3-perylenyl, 2-fluorenyl, 3-fluorenyl, 4-fluorenyl, 1-biphenylenyl, 2-biphenylenyl, 2-phenanthrenyl, 9-phenanthrenyl, 6-chrysenyl, 1-coronenyl, 2-phenylphenyl, 3-phenylphenyl, 4-phenylphenyl, 4-(anthran-9-yl)phenyl, [1,1']binaphthalen-4-yl, 10-phenylanthracen-9-yl and [9,9']bianthracene-10-yl. Some or all of the hydrogen atoms in these groups may be optionally replaced by alkyl, alkoxy, alkyloxycarbonyl, acyl, N,N-dialkylamino, N,N-diarylamino, cyano, nitro, chlorine atom, fluorine atom or the like, but the number of carbon atoms of these substituents are not included in the number of carbon atoms of the aryl groups.

The number of carbon atoms of the aryloxy group is preferably 6-60 and more preferably 7-48. Specific examples of aryloxy groups include phenoxy, C₁-C₁₈ alkoxyphenoxy ("C₁-C₁₈ alkoxy" means 1-18 carbon atoms in the alkoxy portion, same hereunder), C₁-C₁₈ alkylphenoxy ("C₁-C₁₈ alkyl" means 1-18 carbon atoms in the alkyl portion, same hereunder), 1-naphthyloxy, 2-naphthyloxy and pentafluorophenyloxy. Preferred among these are C₁-C₁₈ alkoxyphenoxy and C₁-C₁₈ alkylphenoxy groups, from the viewpoint of satisfactory balance between solubility in organic solvents and heat resistance of the polymer compound. Specific examples of C₁-C₁₈ alkoxyphenoxy groups include methoxyphenoxy, ethoxyphenoxy, propyloxyphenoxy, i-propyloxyphenoxy, butoxyphenoxy, i-butoxyphenoxy, t-butoxyphenoxy, pentyloxyphenoxy, hexyloxyphenoxy, cyclohexyloxyphenoxy, heptyloxyphenoxy, octyloxyphenoxy, 2-ethylhexyloxyphenoxy, nonyloxyphenoxy, decyloxyphenoxy, 3,7-dimethyloctyloxyphenoxy, undecyloxyphenoxy, dodecyloxyphenoxy, tetradecyloxyphenoxy, hexadecyloxyphenoxy and octadecyloxyphenoxy. Specific examples of C₁-C₁₈ alkylphenoxy groups include methylphenoxy, ethylphenoxy, dimethylphenoxy, propylphenoxy, 1,3,5-trimethylphenoxy, methylethylphenoxy, i-propylphenoxy, butylphenoxy, i-butylphenoxy, t-butylphenoxy, pentylphenoxy, isoamylphenoxy, hexylphenoxy, heptylphenoxy, octylphenoxy, nonylphenoxy, decylphenoxy, undecylphenoxy, dodecylphenoxy, tetradecylphenoxy, hexadecylphenoxy and octadecylphenoxy.

The number of carbon atoms in the arylthio group is preferably 3-60. Specific examples of arylthio groups include phenylthio, C₁-C₁₈ alkoxyphenylthio, C₁-C₁₈ alkylphenylthio, 1-naphthylthio, 2-naphthylthio and pentafluorophenylthio. Preferred among these are C₁-C₁₈ alkoxyphenylthio and C₁-C₁₈ alkylphenylthio groups, from the viewpoint of satisfactory balance between solubility in organic solvents and heat resistance of the polymer compound.

The number of carbon atoms of the arylalkyl group is preferably 7-60 and more preferably 7-48. Specific examples of arylalkyl groups include phenyl-C₁-C₁₈ alkyl, C₁-C₁₈ alkoxyphenyl-C₁-C₁₈ alkyl, C₁-C₁₈ alkylphenyl-C₁-C₁₈ alkyl, 1-naphthyl-C₁-C₁₈ alkyl and 2-naphthyl-C₁-C₁₈ alkyl. Of these, C₁-C₁₈ alkoxyphenyl-C₁-C₁₈ alkyl and C₁-C₁₈ alkylphenyl-C₁-C₁₈ alkyl groups are preferred from the viewpoint of satisfactory balance between solubility in organic solvents and heat resistance of the polymer compound.

The number of carbon atoms in the arylalkoxy group is preferably 7-60 and more preferably 7-48. Specific examples of arylalkoxy groups include phenyl-C₁-C₁₈ alkoxy groups such as phenylmethoxy, phenylethoxy, phenylbutoxy, phenylpentyloxy, phenylhexyloxy, phenylheptyloxy and phenyloctyloxy, C₁-C₁₈ alkoxyphenyl-C₁-C₁₈ alkoxy, C₁-C₁₈ alkylphenyl-C₁-C₁₈ alkoxy, 1-naphthyl-C₁-C₁₈ alkoxy and 2-naphthyl-C₁-C₁₈ alkoxy groups. Of these, C₁-C₁₈ alkoxyphenyl-C₁-C₁₈ alkoxy and C₁-C₁₈ alkylphenyl-C₁-C₁₈ alkoxy groups are preferred from the viewpoint of satisfactory balance between solubility in organic solvents and heat resistance of the polymer compound.

The number of carbon atoms of the arylalkylthio group is preferably 7-60 and more preferably 7-48. Specific examples of the arylalkylthio group include phenyl-C₁-C₁₈ alkylthio, C₁-C₁₈ alkoxyphenyl-C₁-C₁₈ alkylthio, C₁-C₁₈ alkylphenyl-C₁-C₁₈ alkylthio, 1-naphthyl-C₁-C₁₈ alkylthio and 2-naphthyl-C₁-C₁₈ alkylthio. Of these, C₁-C₁₈ alkoxyphenyl-C₁-C₁₈ alkylthio and C₁-C₁₈ alkylphenyl-C₁-C₁₈ alkylthio groups are preferred from the viewpoint of satisfactory balance between solubility in organic solvents and heat resistance of the polymer compound.

Substituted silyl groups include silyl groups in which the hydrogen atoms have been substituted with 1, 2 or 3 groups selected from the group consisting of alkyl, aryl, arylalkyl and monovalent heterocyclic groups. The numbers of carbon atoms of the substituted silyl groups are preferably 1-60 and more preferably 3-48. The alkyl, aryl, arylalkyl or monovalent heterocyclic groups that are substituents of the silyl groups may optionally be further substituted, and the number of carbons of the substituents are not included in the number of carbons of the substituted silyl groups. Examples of such substituted silyl groups include trimethylsilyl, triethylsilyl, tripropylsilyl, tri-i-propylsilyl, dimethyl-i-propylsilyl, diethyl-i-propylsilyl, t-butylsilyldimethylsilyl, pentyldimethylsilyl, hexyldimethylsilyl, heptyldimethylsilyl, octyldimethylsilyl, 2-ethylhexyl-dimethylsilyl, nonyldimethylsilyl, decyldimethylsilyl, 3,7-dimethyloctyldimethylsilyl, undecyldimethylsilyl, dodecyldimethylsilyl, tetradecyldimethylsilyl, hexadecyldimethylsilyl, octadecyldimethylsilyl, phenyl-C₁-C₁₈ alkylsilyl, C₁-C₁₈ alkoxyphenyl-C₁-C₁₈ alkylsilyl, C₁-C₁₈ alkylphenyl-C₁-C₁₈ alkylsilyl, 1-naphthyl-C₁-C₁₈ alkylsilyl, 2-naphthyl-C₁-C₁₈ alkylsilyl, phenyl-C₁-C₁₈ alkyldimethylsilyl, triphenylsilyl, tri-p-xylylsilyl, tribenzylsilyl, diphenylmethylsilyl, t-butyldiphenylsilyl and dimethylphenylsilyl.

Substituted carboxyl groups include carboxyl groups in which hydrogen atoms have been replaced by alkyl, aryl, arylalkyl or monovalent heterocyclic groups. The number of carbon atoms of the substituted carboxyl groups are preferably 2-60 and more preferably 2-48. Specific examples of substituted carboxyl groups include methoxycarbonyl, ethoxycarbonyl, propoxycarbonyl, i-propoxycarbonyl, butoxycarbonyl, i-butoxycarbonyl, t-butoxycarbonyl, pentyloxycarbonyl, hexyloxycarbonyl, cyclohoxyloxycarbonyl, heptyloxycarbonyl, octyloxycarbonyl, 2-ethylhexyloxycarbonyl, nonyloxycarbonyl, decyloxycarbonyl, 3,7-dimethyloctyloxycarbonyl, undecyloxycarbonyl, dodecyloxycarbonyl, tetradecyloxycarbonyl, hexadecyloxycarbonyl, octadecyloxycarbonyl, trifluoromethoxycarbonyl, pentafluoroethoxycarbonyl, perfluorobutoxycarbonyl, perfluorohexyloxycarbonyl, perfluorooctyloxycarbonyl, phenoxycarbonyl, naphthoxycarbonyl and pyridyloxycarbonyl. The alkyl, aryl, arylalkyl or monovalent heterocyclic groups that are substituents of the carboxyl groups may optionally be further substituted, and the number of carbons of the substituents are not included in the number of carbons of the substituted carboxyl groups.

The number of carbon atoms of the monovalent heterocyclic group is preferably 4-60 and more preferably 4-20. Specific examples of monovalent heterocyclic groups include thienyl, pyrrolyl, furyl, pyridyl, piperidyl, quinolyl, isoquinolyl, pyrimidyl and triazinyl. Preferred among these are thienyl, pyridyl, quinolyl, isoquinolyl, pyrimidyl and triazinyl, with thienyl, pyridyl, pyrimidyl and triazinyl being more preferred. The monovalent heterocyclic group may be optionally substituted with alkyl, alkoxy or the like, and the number of carbons of the substituents are not included in the number of carbons of the monovalent heterocyclic group.

From the viewpoint of achieving more satisfactory packing of the main chain of the polymer compound for even higher charge mobility, the positions of substitution of the substituents of formula (1) or (2) are preferably positions that produce a structure with line symmetry around any desired axis in the repeating unit, or point symmetry around the center of gravity.

From the viewpoint of more satisfactory packing of the main chains of the polymer compounds in order to further improve the charge mobility, as mentioned above, preferably R³ and R⁵, and/or R⁴ and R⁶ in formula (1) are the same groups. Likewise, R¹³ and R¹⁵, and/or R¹⁴ and R¹⁶ in formula (2) are also preferably the same groups. Here, "the same groups" means groups classified as the same type, such as alkyl groups or alkoxy groups. These same groups are more preferably groups with identical structures with the same chain lengths, branching positions and substituents.

Also, from the viewpoint of achieving even more satisfactory packing of the main chain of the polymer compound and further improving planarity in the main chain, for even further improved charge mobility, R³, R⁴, R⁵ and R⁶ in formula (1) are preferably hydrogen atoms. Likewise, in formula (2), R¹³, R¹⁴, R¹⁵ and R¹⁶ are preferably hydrogen atoms.

Specifically, the repeating unit represented by formula (1) is preferably a repeating unit represented by the following formula (10), and the repeating unit represented by formula (2) is preferably a repeating unit represented by the following formula (11). X¹, X² , X¹¹ and X¹² in formulas (10) and (11) have the same definitions as X¹, X², X¹¹ and X¹² in formulas (1) and (2).

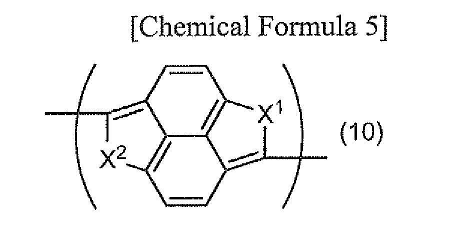

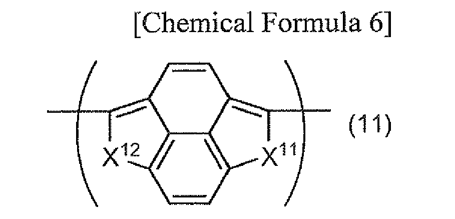

The polymer compound also has a repeating unit represented by formula (3) above.

In formula (3), Y represents an arylene group comprising 3 or more fused aromatic rings that may be optionally substituted, an optionally substituted divalent heterocyclic group, an optionally substituted divalent group with a metal complex structure, or the group -C≡C-.

An arylene group comprising 3 or more fused aromatic rings is an atomic group derived by removing 2 hydrogen atoms from a polycyclic aromatic hydrocarbon having 3 or more fused aromatic rings, and the term includes those with independent benzene rings or fused rings. In an arylene group having less than 3 aromatic fused aromatic rings, the charge mobility of the polymer compound will be insufficient, and this is therefore undesirable. Also, if the number of fused rings of the aromatic ring is excessive there will be a tendency toward oxidation, and this is undesirable from the standpoint of stability in organic thin-film transistor production processes, and usable life during device driving. Thus, the number of fused rings is preferably at least 3 and no greater than 7, and more preferably it is at least 3 and no greater than 5. Also, the arylene group comprising 3 or more fused aromatic rings is most preferably a group derived by removing 2 hydrogen atoms from an acene compound with 3-5 rings.

Specific examples of arylene groups comprising 3 or more fused aromatic rings include unsubstituted or substituted anthracenediyl groups such as 1,4-anthracenediyl, 1,5-anthracenediyl, 2,6-anthracenediyl or 9,10-anthracenediyl; unsubstituted or substituted phenanthrenediyl groups such as 2,7-phenanthrenediyl; unsubstituted or substituted naphthacenediyl groups such as 1,7-naphthacenediyl, 2,8-naphthacenediyl or 5,12-naphthacenediyl; unsubstituted or substituted pyrenediyl groups such as 1,6-pyrenediyl, 1,8-pyrenediyl, 2,7-pyrenediyl or 4,9-pyrenediyl; and unsubstituted or substituted perylenediyl groups such as 3,9-perylenediyl or 3,10-perylenediyl. Preferred among these are unsubstituted or substituted anthracenediyl groups.

The divalent heterocyclic groups have preferably 4-60, more preferably 4-48, even more preferably 4-30, yet more preferably 4-22, even yet more preferably 4-12 and most preferably 4 carbon atoms. A divalent heterocyclic group may have substituents, but the numbers of carbons of the substituents are not included in the number of carbons in the divalent heterocyclic group. Specific examples of divalent heterocyclic groups include unsubstituted or substituted thiophenediyl groups such as 2,5-thiophenediyl; unsubstituted or substituted furanediyl groups such as 2,5-furanediyl; unsubstituted or substituted pyridinediyl groups such as 2,5-pyridinediyl or 2,6-pyridinediyl; unsubstituted or substituted quinolinediyl groups such as 2,6-quinolinediyl; unsubstituted or substituted isoquinolinediyl groups such as 1,4-isoquinolinediyl or 1,5-isoquinolinediyl; unsubstituted or substituted quinoxalinediyl groups such as 5,8-quinoxalinediyl; unsubstituted or substituted benzo[1,2,5]thiadiazolediyl groups such as 4,7-benzo[1,2,5]thiadiazolediyl; unsubstituted or substituted benzothiazolediyl groups such as 4,7-benzothiazolediyl; unsubstituted or substituted carbazolediyl groups such as 2,7-carbazolediyl or 3,6-carbazolediyl; unsubstituted or substituted phenoxazinediyl groups such as 3,7-phenoxazinediyl; unsubstituted or substituted phenothiazinediyl groups such as 3,7-phenothiazinediyl; and unsubstituted or substituted dibenzosiloldiyl groups such as 2,7-dibenzosiloldiyl. Among these are preferred unsubstituted or substituted thiophenediyl groups such as 2,5-thiophenediyl; unsubstituted or substituted furanediyl groups such as 2,5-furanediyl; unsubstituted or substituted pyridinediyl groups such as 2,5-pyridinediyl or 2,6-pyridinediyl; unsubstituted or substituted quinolinediyl groups such as 2,6-quinolinediyl; and 1,4-isoquinolinediyl groups, with unsubstituted or substituted thiophenediyl groups such as 2,5-thiophenediyl being more preferred.

When the divalent heterocyclic group has substituents, preferred substituents are selected from the group consisting of alkyl, alkoxy, alkylthio, aryl, aryloxy, arylthio, arylalkyl, arylalkoxy, arylalkylthio, substituted silyl, monovalent heterocyclic groups, substituted carboxyl, nitro, cyano and fluorine atoms. More preferred among these are alkyl, alkoxy, aryl, aryloxy and monovalent heterocyclic groups, with alkyl, alkoxy and alkylthio groups being even more preferred and alkyl groups being most preferred. From the viewpoint of satisfactory balance between solubility of the polymer compound in organic solvents and heat resistance, the alkyl groups are preferably C6-20 alkyl groups and more preferably C8-18 alkyl groups.

A divalent group having a metal complex structure is an atomic group remaining after removing two hydrogen atoms from the organic ligand of a metal complex having an organic ligand and a central metal. Metal complexes include metal complexes known as low molecular fluorescent materials and phosphorescent materials and triplet emitting complexes.

The number of carbons of the organic ligand in the metal complex is preferably 4-60. Such organic ligands include 8-quinolinol and its derivatives, benzoquinolinol and its derivatives, 2-phenyl-pyridine and its derivatives, 2-phenyl-benzothiazole and its derivatives, 2-phenyl-benzoxazole and its derivatives and porphyrin and its derivatives.

Examples of central metals for the metal complex include aluminum, zinc, beryllium, iridium, platinum, gold, europium and terbium.

In formula (3), n is an integer of 1-5, preferably an integer of 1-4, more preferably an integer of 1-3 and even more preferably 1 or 2.

When there are a plurality of Y groups in formula (3), they may be the same or different, but they are preferably the same.

From the viewpoint of further improving the charge mobility, the repeating unit represented by formula (3) is most preferably a repeating unit represented by formula (4) above.

In formula (4), R²⁰, R²¹, R²² and R²³ are the same or different and each represents hydrogen atom, alkyl, alkoxy, alkylthio, optionally substituted aryl, aryloxy, arylalkyl, arylalkoxy, substituted silyl, carboxyl, an optionally substituted monovalent heterocyclic group, cyano or fluorine atom. From the viewpoint of obtaining a satisfactory balance between solubility of the polymer compound in organic solvents and heat resistance, at least one from among R²⁰, R²¹, R²² and R²³ in formula (4) is preferably a C6-20 alkyl group, and more preferably R²⁰ and R²³, and/or R²¹ and R²², are C6-20 alkyl groups. The number of carbon atoms of the alkyl groups is more preferably C8-18 from the same viewpoint mentioned above.

In a polymer compound used in the organic thin-film transistor of the invention, the percentage of the total number of moles of repeating units represented by formula (1) and/or repeating units represented by formula (2), with respect to the total number of moles of the total repeating units, is preferably 20-80%, more preferably 30-70%, even more preferably 40-60% and most preferably 45-55%, from the viewpoint of obtaining a satisfactory charge injection property and solubility in organic solvents for the polymer compound.

Also, when the polymer compound has both a repeating unit represented by formula (1) and a repeating unit represented by formula (2), the percentage of the number of moles of the less abundant repeating unit with respect to the total number of moles of repeating units represented by formula (1) and repeating units represented by formula (2) is preferably no greater than 10%, more preferably no greater than 5%, even more preferably no greater than 1% and most preferably no greater than 0.05%, from the viewpoint of obtaining satisfactory orientation of the main chain of the polymer compound.

In addition, from the viewpoint of the charge injection property and the solubility in organic solvents for the polymer compound, the percentage of the total number of moles of repeating units represented by formula (3) with respect to the total number of moles of the total repeating units is preferably 20-80%, more preferably 30-70%, even more preferably 40-60% and most preferably 45-55%.

For example, the polymer compound may be any copolymer, such as a block copolymer, random copolymer, alternating copolymer or graft copolymer. However, from the viewpoint of obtaining a more satisfactory charge mobility property for the polymer compound, it preferably has a structure in which a repeating unit represented by formula (1) and/or a repeating unit represented by formula (2), and a repeating unit represented by formula (3), are alternately bonded. Also, from the viewpoint of obtaining the aforementioned property more satisfactorily, the polymer compound more preferably has a structure in which a repeating unit represented by either formula (1) or (2), and a repeating unit represented by formula (3), are alternately bonded, and most preferably it has a structure in which a repeating unit represented by formula (1) and a repeating unit represented by formula (3) are alternately bonded.

From the viewpoint of obtaining a more satisfactory charge mobility property for the polymer compound, the percentage of repeating units included in the structure in which a repeating unit represented by formula (1) and/or a repeating unit represented by formula (2), and a repeating unit represented by formula (3), are alternately bonded, with respect to the total repeating units, is preferably at least 90%, more preferably at least 99%, even more preferably at least 99.5% and most preferably at least 99.9%.

The polymer compound also has a weight-average molecular weight (Mw) of preferably between 1 × 10³ and 1 × 10⁸, and from the viewpoint of film formability, more preferably between 1 × 10⁴ and 5 × 10⁶ and most preferably between 1 × 10⁴ and 5 × 10⁵, in terms of polystyrene, as measured by gel permeation chromatography (hereunder, "GPC").

The end groups of the polymer compound are preferably stable groups. Such end groups are preferably conjugated with the main chain, and for example, the structure may include bonding with aryl or heterocyclic groups via carbon-carbon bonds. Specific examples include end groups such as the substituents mentioned for compound 10 of Japanese Unexamined Patent Application Publication HEI No. 9-45478.

### (Method for producing polymer compound)

A preferred method for producing a polymer compound having the structure described above will now be explained.

The polymer compound may be produced, for example, by condensation polymerization of one or more compounds represented by the following formula (5) or (6), and one or more compounds represented by the following formula (7).

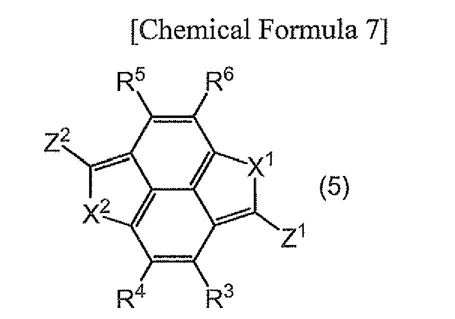

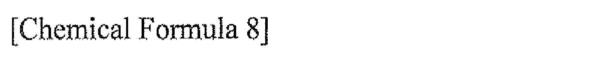

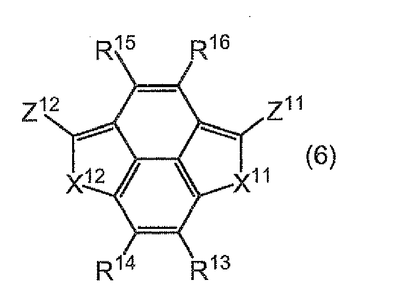

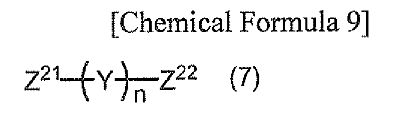

In formulas (5) to (7), X¹, X², X¹¹, X¹², R³-R⁶, R¹³-R¹⁶ and n have the same definitions as formulas (1) to (3) above. Also, groups Z¹, Z², Z¹¹, Z¹², Z²¹ and Z²² are the same or different and each represents a halogen atom, a sulfonate group represented by the following formula (a-1), methoxy, a boric acid ester residue, a boric acid residue (i.e. the group represented by -B(OH)₂), a group represented by the following formula (a-2), a group represented by the following formula (a-3), or a group represented by the following formula (a-4).

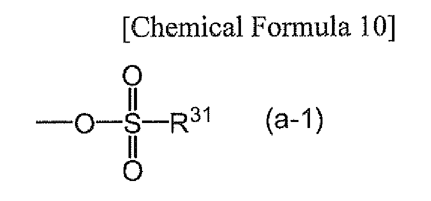

In the formula, R³¹ represents unsubstituted or substituted alkyl or unsubstituted or substituted aryl.

[Chemical Formula 11] -MgX^{A} (a-2)

In the formula, X^{A} represents a halogen atom.

[Chemical Formula 12] -ZnX^{A} (a-3)

In the formula, X^{A} represents a halogen atom.

[Chemical Formula 13] -Sn(R³²)₃ (a-4)

In the formula, R³² represents unsubstituted or substituted alkyl or unsubstituted or substituted aryl. A plurality of R³² groups may be the same or different.

In formulas (5) to (7), (a-2) and (a-3), halogen atoms represented by Z¹, Z², Z¹¹, Z¹², Z²¹, Z²² and X^{A} may be chlorine, bromine or iodine atoms.

In formulas (5) to (7), boric acid ester residues represented by Z¹, Z², Z¹¹, Z¹², Z²¹ and Z²² may be groups represented by the following chemical formulas, for example.

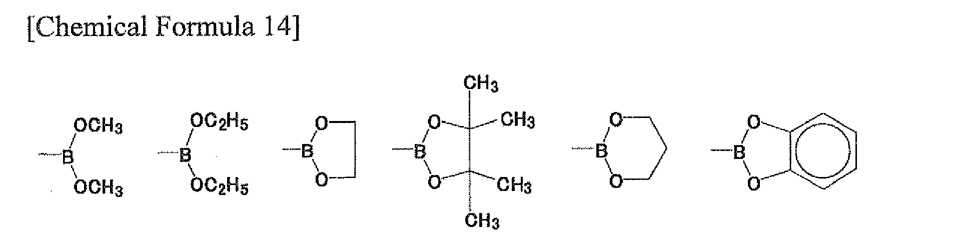

In formula (a-1), the definitions and specific examples of alkyl and aryl groups represented by R³¹ are the same as the definitions and specific examples mentioned above for the substituents R³-R⁶ and R¹³-R¹⁶ in formulas (1) and (2). As examples of sulfonate groups represented by formula (a-1) there may be mentioned methane sulfonate, trifluoromethane sulfonate, phenyl sulfonate and 4-methylphenyl sulfonate.

In formula (a-4), the definitions and specific examples of alkyl and aryl groups represented by R³² are the same as the definitions and specific examples mentioned above for the substituents R³-R⁶ and R¹³-R¹⁶ in formulas (1) and (2). Examples of groups represented by formula (a-4) include trimethylstannanyl, triethylstannanyl and tributylstannanyl.

The compounds represented by formulas (5) to (7) may be ones that have been synthesized and isolated beforehand, or they may be prepared in the reaction system.

In formulas (5) to (7), Z¹, Z², Z¹¹, Z¹², Z²¹ and Z²² are preferably halogen atoms, boric acid ester residues or boric acid residues, for more convenient synthesis and easier handling of the compounds represented by formulas (5) to (7).

The method of condensation polymerization may be a method of reaction of a compound represented by any of formulas (5) to (7), using an appropriate catalyst and an appropriate base, as necessary.

Examples of catalysts to be used for the reaction include transition metal complexes, for example, palladium complexes such as palladium [tetrakis(triphenylphosphine)], [tris(dibenzylideneacetone)]dipalladium and palladium acetate, nickel complexes such as nickel [tetrakis(triphenylphosphine)], [1,3-bis(diphenylphosphino)propane]dichloronickel and [bis(1,4-cyclooctadiene)]nickel, and catalysts comprising these transition metal complexes and ligands such as triphenylphosphine, tri(t-butylphosphine), tricyclohexylphosphine, diphenylphosphinopropane and bipyridyl. The catalyst may be synthesized beforehand or prepared in the reaction system and used directly. These catalysts may be used alone or in combinations of two or more.

When such a catalyst is used, the amount is preferably 0.00001-3 mol equivalents, more preferably 0.00005-0.5 mol equivalents and even more preferably 0.0001-0.2 mol equivalents, as the amount of transition metal compound with respect to the total number of moles of the compound represented by formula (5) to (7).

Examples of bases to be used in the reaction include inorganic bases such as sodium carbonate, potassium carbonate, cesium carbonate, potassium fluoride, cesium fluoride and tripotassium phosphate, and organic bases such as tetrabutylammonium fluoride, tetrabutylammonium chloride, tetrabutylammonium bromide and tetrabutylammonium hydroxide.

The amount of base used is preferably 0.5-20 mol equivalents and more preferably 1-10 mol equivalents with respect to the total number of moles of the compounds represented by formula (5) to (7).

The condensation polymerization may be conducted in the absence of a solvent or in the presence of a solvent, but it is preferably conducted in the presence of an organic solvent.

The organic solvent will differ depending on the type of compound represented by formula (5) to (7) and on the type of polymerization reaction, and examples include toluene, xylene, mesitylene, tetrahydrofuran, 1,4-dioxane, dimethoxyethane, N,N-dimethylacetamide and N,N-dimethylformamide. In order to minimize secondary reactions, the solvent is generally preferred to be one that has been subjected to deoxidizing treatment. These organic solvents may be used alone or in combinations of two or more.

The amount of organic solvent, when used, is an amount such that the total concentration of the compounds represented by formula (5) to (7) is preferably 0.1-90 mass%, more preferably 1-50 mass% and even more preferably 2-30 mass%.

The reaction temperature for condensation polymerization is preferably between -100°C and 200°C, more preferably between -80°C and 150°C and even more preferably between 0°C and 120°C.

The reaction time for the condensation polymerization will depend on the conditions such as the reaction temperature, but it is preferably 1 hour or greater and more preferably 2-500 hours.

The condensation polymerization is preferably carried out under dehydrating conditions. For example, when Z¹, Z², Z¹¹, Z¹², Z²¹ and Z²² in formulas (5) to (7) are groups represented by formula (a-2), the reaction is preferably conducted under dehydrating conditions.

The method of condensation polymerization may be, for example, a method of polymerization by Suzuki reaction (Chem. Rev. Vol. 95, p.2457(1995)), a method of polymerization by Grignard reaction (Kobunshi Kinou Zairyo Series Vol.2, "Polymer Syntheses and Reactions (2), p.432-433, Kyoritsu Publishing), or a method of polymerization by Yamamoto polymerization (Prog. Polym. Sci., Vol. 17, p.1153-1205, 1992).

Post-treatment after condensation polymerization may be carried out by a known method, such as adding the reaction mixture obtained by condensation polymerization to a lower alcohol such as methanol and filtering and drying the deposited precipitate.

Such post-treatment can yield a polymer compound of the invention, but if the purity of the polymer compound is low it may be purified by common methods such as recrystallization, continuous extraction with a Soxhlet extractor, or column chromatography.

For copolymerization of a compound represented by either formula (5) or (6) and a compound represented by formula (7), they are preferably present as alternating repeating units, and it is therefore preferred to polymerize a combination of a compound of formula (5) or (6) wherein Z¹, Z², Z¹¹ and Z¹² are halogen atoms and a compound of formula (7) wherein Z²¹ and Z²² are boric acid residues or boric acid ester residues, or a combination of a compound of formula (5) or (6) wherein Z¹, Z², Z¹¹ and Z¹² are boric acid residues or boric acid ester residues and a compound of formula (7) wherein Z²¹ and Z²² are halogen atoms, using Suzuki polymerization.

In formula (5), R³ and R⁵, and/or R⁴ and R⁶, are preferably the same groups, and in formula (6), R¹³ and R¹⁵, and/or R¹⁴ and R¹⁶, are preferably the same groups. More preferably, R³, R⁴, R⁵ and R⁶ in formula (5) are hydrogen atoms and R¹³, R¹⁴, R¹⁵ and R¹⁶ in formula (6) are hydrogen atoms.

### (Organic thin-film transistor)

A preferred embodiment of an organic thin-film transistor of the invention, provided with an organic semiconductor layer comprising the polymer compound described above, will now be explained.

The organic thin-film transistor has a structure comprising a source electrode and drain electrode, an organic semiconductor layer (active layer) containing the aforementioned polymer compound which acts as a current channel between them, and a gate electrode that controls the level of current flowing through the current channel, and the transistor may be a field-effect type or static induction type, for example.

An organic thin-flm field-effect transistor may have a structure comprising a source electrode and drain electrode, an organic semiconductor layer (active layer) which acts as a current channel between them, a gate electrode that controls the level of current flowing through the current channel, and an insulating layer situated between the organic semiconductor layer and the gate electrode. Preferably, the source electrode and drain electrode are provided in contact with the organic semiconductor layer (active layer), and the gate electrode is provided sandwiching the insulating layer which is also in contact with the organic semiconductor layer.

A static induction-type organic thin-film transistor has a structure comprising a source electrode and drain electrode, an organic semiconductor layer (active layer) which acts as a current channel between them, and a gate electrode that controls the level of current flowing through the current channel, preferably with the gate electrode in the organic semiconductor layer. Most preferably, the source electrode, the drain electrode and the gate electrode formed in the organic semiconductor layer are provided in contact with the organic semiconductor layer. The structure of the gate electrode may be any one that forms a current channel for flow from the source electrode to the drain electrode, and that allows the level of current flowing through the current channel to be controlled by the voltage applied to the gate electrode; an example of such a structure is a combshaped electrode.

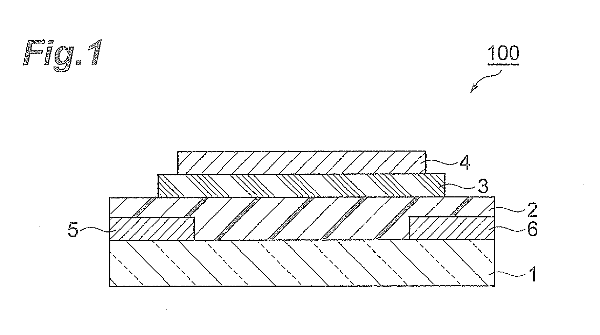

Fig. 1 is a schematic cross-sectional view of an organic thin-film transistor (organic thin-film field-effect transistor) according to a first embodiment. The organic thin-film transistor 100 shown in Fig. 1 comprises a substrate 1, a source electrode 5 and drain electrode 6 formed at a fixed spacing on the substrate 1, an organic semiconductor layer 2 formed on the substrate 1 covering the source electrode 5 and drain electrode 6, an insulating layer 3 formed on the organic semiconductor layer 2, and a gate electrode 4 formed on the insulating layer 3 covering the region of the insulating layer 3 between the source electrode 5 and drain electrode 6.

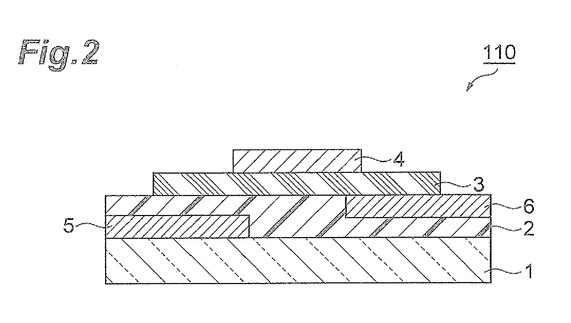

Fig. 2 is a schematic cross-sectional view of an organic thin-film transistor (organic thin-film field-effect transistor) according to a second embodiment. The organic thin-film transistor 110 shown in Fig. 2 comprises a substrate 1, a source electrode 5 formed on the substrate 1, an organic semiconductor layer 2 formed on the substrate 1 covering the source electrode 5, a drain electrode 6 formed on the organic semiconductor layer 2 at a prescribed spacing from the source electrode 5, an insulating layer 3 formed on the organic semiconductor layer 2 and drain electrode 6, and a gate electrode 4 formed on the insulating layer 3 covering the region of the insulating layer 3 between the source electrode 5 and drain electrode 6.

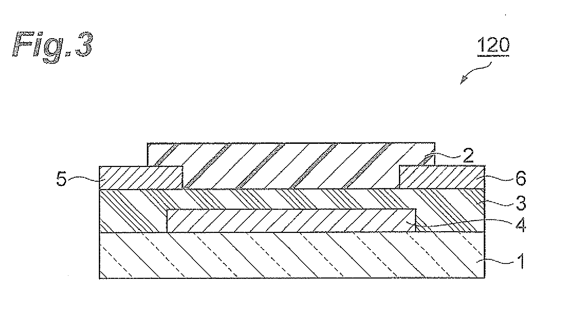

Fig. 3 is a schematic cross-sectional view of an organic thin-film transistor (organic thin-film field-effect transistor) according to a third embodiment. The organic thin-film transistor 120 shown in Fig. 3 comprises a substrate 1, a gate electrode 4 formed on the substrate 1, an insulating layer 3 formed on the substrate 1 covering the gate electrode 4, a source electrode 5 and drain electrode 6 formed at a prescribed spacing on the insulating layer 3 covering portions of the region of the insulating layer 3 under which the gate electrode 4 is formed, and an organic semiconductor layer 2 formed on the insulating layer 3 covering portions of the source electrode 5 and drain electrode 6.

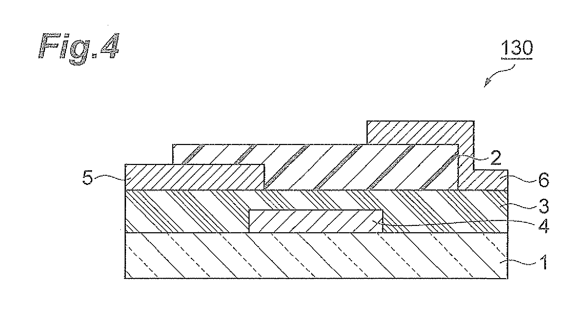

Fig. 4 is a schematic cross-sectional view of an organic thin-film transistor (organic thin-film field-effect transistor) according to a fourth embodiment. The organic thin-film transistor 130 shown in Fig. 4 comprises a substrate 1, a gate electrode 4 formed on the substrate 1, an insulating layer 3 formed on the substrate 1 covering the gate electrode 4, a source electrode 5 formed on the insulating layer 3 covering a portion of the region of the insulating layer 3 under which the gate electrode 4 is formed, an organic semiconductor layer 2 formed on the insulating layer 3 covering a portion of the source electrode 5, and a drain electrode 6 formed on the insulating layer 3 at a prescribed spacing from the source electrode 5 and covering a portion of the region of the organic semiconductor layer 2 under which the gate electrode 4 is formed.

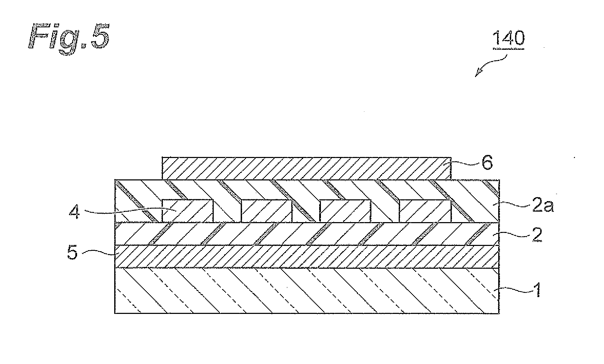

Fig. 5 is a schematic cross-sectional view of an organic thin-film transistor (static induction-type organic thin-film transistor) according to a fifth embodiment. The organic thin-film transistor 140 shown in Fig. 5 comprises a substrate 1, a source electrode 5 formed on the substrate 1, an organic semiconductor layer 2 formed on the source electrode 5, a plurality of gate electrodes 4 formed at prescribed spacings on the organic semiconductor layer 2, an organic semiconductor layer 2a formed on the organic semiconductor layer 2 covering all of the gate electrodes 4, (the material composing the organic semiconductor layer 2a may be the same as or different from that of the organic semiconductor layer 2) and a drain electrode 6 formed on the organic semiconductor layer 2a.

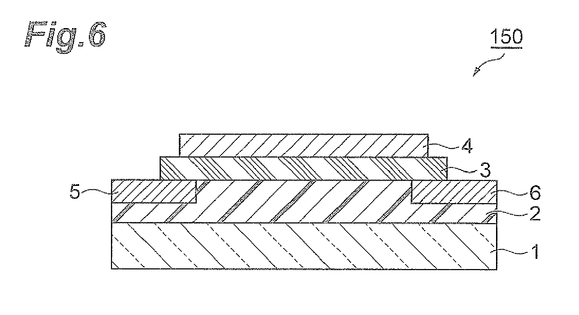

Fig. 6 is a schematic cross-sectional view of an organic thin-film transistor (organic thin-film field-effect transistor) according to a sixth embodiment. The organic thin-film transistor 150 shown in Fig. 6 comprises a substrate 1, an organic semiconductor layer 2 formed on the substrate 1, a source electrode 5 and drain electrode 6 formed at a prescribed spacing on the organic semiconductor layer 2, an insulating layer 3 formed on the organic semiconductor layer 2 covering portions of the source electrode 5 and drain electrode 6, and a gate electrode 4 formed on the insulating layer 3, covering a portion of the region of the insulating layer 3 under which the source electrode 5 is formed and a portion of the region of the insulating layer 3 under which the drain electrode 6 is formed.

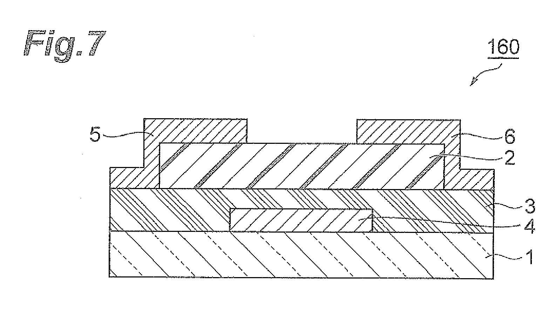

Fig. 7 is a schematic cross-sectional view of an organic thin-film transistor (organic thin-film field-effect transistor) according to a seventh embodiment. The organic thin-film transistor 160 shown in Fig. 7 comprises a substrate 1, a gate electrode 4 formed on the substrate 1, an insulating layer 3 formed on the substrate 1 covering the gate electrode 4, an organic semiconductor layer 2 formed covering the region of the insulating layer 3 under which the gate electrode 4 is formed, a source electrode 5 formed on the organic semiconductor layer 2 covering a portion of the region of the organic semiconductor layer 2 under which the gate electrode 4 is formed, and a drain electrode 6 formed on the organic semiconductor layer 2 at a prescribed spacing from the source electrode 5 and covering a portion of the region of the organic semiconductor layer 2 under which the gate electrode 4 is formed.

In the organic thin-film transistors of the first to seventh embodiments described above, the organic semiconductor layer 2 and/or the organic semiconductor layer 2a is constructed from an organic thin-film containing the above-described polymer compound, and it forms a current channel between the source electrode 5 and drain electrode 6. The gate electrode 4 controls the level of current flowing through the current channel of the organic semiconductor layer 2 and/or organic semiconductor layer 2a by application of voltage.

Of the organic thin-film transistors described above, this type of organic thin-film field-effect transistor can be manufactured by a publicly known process, such as the process described in Japanese Unexamined Patent Application Publication HEI No. 5-110069, for example. A static induction-type organic thin-film transistor can be manufactured by a publicly known process, such as the process described in Japanese Unexamined Patent Application Publication No. 2004-006476, for example.

The substrate 1 is not particularly restricted so long as it does not impair the characteristics of the organic thin-film transistor, and a glass panel, flexible film substrate or plastic panel may be used.

The organic semiconductor layer 2 comprises the polymer compound described above, and it may consist entirely of the polymer compound, or it may further include materials other than the polymer compound. Also, the organic semiconductor layer 2 may be one comprising only one of the aforementioned polymer compounds, or it may include two or more of such polymer compounds. For an increased electron transport property or hole transport property, the organic semiconductor layer 2 may further contain a low molecular compound or polymer compound having an electron transport property or hole transport property, in addition to the polymer compound mentioned above.

Any known hole transport material may be used, examples of which include pyrazoline derivatives, arylamine derivatives, stilbene derivatives, triaryldiamine derivatives, oligothiophene and its derivatives, polyvinylcarbazole and its derivatives, polysilane and its derivatives, polysiloxane derivatives with aromatic amines on the side chains or main chain, polyaniline and its derivatives, polythiophene and its derivatives, polypyrrole and its derivatives, polyarylenevinylene and its derivatives, and polythienylenevinylene and its derivatives.

Any known electron transport material may be used, examples of which include oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and C₆₀ or other fullerenes and their derivatives.

The organic semiconductor layer 2 may also contain high molecular compound materials as high molecular binders in addition to the compounds mentioned above, in order to improve the mechanical properties. As high molecular binders there are preferably used ones that produce minimal interference with the electron transport or hole transport property, and ones with weak absorption for visible light.

Examples of such high molecular binders include poly(N-vinylcarbazole), polyaniline and its derivatives, polythiophene and its derivatives, poly(p-phenylenevinylene) and its derivatives, poly(2,5-thienylenevinylene) and its derivatives, polycarbonates, polyacrylates, polymethyl acrylates, polymethyl methacrylates, polystyrenes, polyvinyl chlorides, polysiloxanes and the like.

The film thickness of the organic semiconductor layer 2 is preferably 1 nm-100 µm, more preferably 2 nm-1000 nm, even more preferably 3 nm-500 nm and most preferably 5 nm-200 nm.

The method for producing the organic semiconductor layer 2 may be, for example, a method of film formation using a solution comprising the aforementioned polymer compound and, as necessary, an electron transport or hole transport material and a high molecular binder. When the polymer compound is an oligomer, a thin-film may be formed by vacuum vapor deposition.

The solvent used for formation of the organic semiconductor layer 2 from a solution may be any one that can dissolve the polymer compound and the electron transport material or hole transport material and high molecular binders that are combined therewith as necessary. Examples of such solvents include unsaturated hydrocarbon-based solvents such as toluene, xylene, mesitylene, tetralin, decalin, bicyclohexyl, n-butylbenzene, sec-butylbenzene and tert-butylbenzene; halogenated saturated hydrocarbon-based solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane; halogenated unsaturated hydrocarbon-based solvents such as chlorobenzene, dichlorobenzene and trichlorobenzene; and ether-based solvents such as tetrahydrofuran and tetrahydropyran. For most purposes, the organic semiconductor layer 2 may be formed using a solution of the polymer compound in such a solvent at 0.1 mass% or greater, although this will differ depending on the structure and molecular weight of the polymer compound.

The method of forming the organic semiconductor layer 2 from a solution may be a coating method such as spin coating, casting, microgravure coating, gravure coating, bar coating, roll coating, wire bar coating, dip coating , spray coating, screen printing, flexographic printing, offset printing , ink jet printing, dispenser printing or the like, among which spin coating, flexographic printing, ink jet printing and dispenser printing methods are preferred.

A step of orienting the polymer compound may also be carried out for production of the organic semiconductor layer 2. This step can yield an organic semiconductor layer 2 comprising the polymer compound in an oriented state. Such an organic semiconductor layer 2 is preferred because it has the main chain molecules or side chain molecules aligned in a single direction, and therefore has improved electron mobility or hole mobility.

The method of orienting the polymer compound may be a known method for orienting liquid crystals. Rubbing, photoorientation, shearing (shear stress application) and pull-up coating methods are convenient, useful and easy orienting methods, and are therefore preferred, with rubbing and shearing being more preferred.

The insulating layer 3 in contact with the organic semiconductor layer 2 may be any material with high electrical insulating properties, and any publicly known one may be used. Examples of structural materials for the insulating layer 3 include SiOx, SiNx, Ta₂O₅, polyimide, polyvinyl alcohol, polyvinylphenol, organic glass and photoresists. From the viewpoint of low voltage, it is preferred to use a material with high permittivity for the insulating layer 3.

When the organic semiconductor layer 2 is to be formed on the insulating layer 3, the organic semiconductor layer 2 may be formed after surface modification by treatment of the surface of the insulating layer 3 with a surface treatment agent such as a silane coupling agent in order to improve the interfacial properties between the insulating layer 3 and organic semiconductor layer 2.

For an organic thin-film field-effect transistor, the electron or hole carrier will usually pass through a section near the interface between the insulating layer 3 and organic semiconductor layer 2. The condition at the interface therefore has a major effect on the transistor mobility. Methods for modifying the condition at the interface to improve the characteristics, by control of the interface using silane coupling agents, are known (for example, see Hyoumen Kagaku, Vol.28, No.5, pp242-248, 2007).

Silane coupling agents include alkylchlorosilanes (octyltrichlorosilane (OTS), octadecyltrichlorosilane (ODTS), phenylethyltrichlorosilane and the like), alkylalkoxysilanes, fluorinated alkylchlorosilanes, fluorinated alkylalkoxysilanes and silylamine compounds such as hexamethyldisilazane (HMDS). Before treatment with the surface treatment agent, the insulating layer surface may be pre-treated by ozone UV or O₂ plasma.

Such treatment can control the surface energy of a silicon oxide film or the like, which is used as the insulating layer 3. The surface treatment also improves the orientation of the polymer compound composing the organic semiconductor layer 2 on the insulating layer 3, thereby resulting in a high carrier transport property (mobility).

The gate electrode 4 may be a metal such as gold, platinum, silver, copper, chromium, palladium, aluminum, indium, molybdenum, low resistance polysilicon, low resistance amorphous silicon or the like, or a material such as tin oxide, indium oxide or indium/tin oxide (ITO). Any of these materials may be used alone or in combinations of two or more. A silicon substrate doped to a high concentration may also be used as the gate electrode 4. A silicon substrate doped to a high concentration has the properties of both a gate electrode and a substrate. When a gate electrode 4 having the properties of a substrate is used, it is possible to omit the substrate 1 in an organic thin-film transistor in which the substrate 1 and gate electrode 4 are in contact. For example, in the organic thin-film transistors of the third, fourth and seventh embodiments described above, the gate electrode 4 may also serve as the substrate 1.

The source electrode 5 and drain electrode 6 are composed of low resistance materials, such as gold, platinum, silver, copper, chromium, palladium, aluminum, indium or molybdenum. From the viewpoint of charge injection, they are preferably made of gold or platinum, and more preferably of gold from the viewpoint of processability. Such materials may be used alone, or two or more may be used in combination.

Several examples were described above as preferred embodiments of organic thin-film transistors, but the organic thin-film transistor is not limited to these embodiments. For example, a layer comprising a different compound from the polymer compound described above may be provided between the source electrode 5 and drain electrode 6 and the organic semiconductor layer 2. This can reduce contact resistance between the source electrode 5 and drain electrode 6 and the organic semiconductor layer 2, to allow the carrier mobility of the organic thin-film transistor to be further increased.

Such a layer may be a layer comprising a low molecular compound with an electron or hole transport property, such as mentioned above; an alkali metal, alkaline earth metal, rare earth metal or a complex of such metals with an organic compound; a halogen such as iodine, bromine, chlorine or iodine chloride; an oxidized sulfur compound such as sulfuric acid, sulfuric anhydride, sulfur dioxide or a sulfuric acid salt; an oxidized nitrogen compound such as nitric acid, nitrogen dioxide or a nitric acid salt; a halogenated compound such as perchloric acid or hypochlorous acid; or an aromatic thiol compound such as an alkylthiol compound, aromatic thiol or fluorinated alkylaromatic thiol.

After an organic thin-film transistor such as described above has been fabricated, a protecting film is preferably formed on the organic thin-film transistor to protect the element. This will shield the organic thin-film transistor from air, helping to prevent reduction in the characteristics of the organic thin-film transistor. A protecting film can also minimize effects on the organic thin-film transistor during the steps of formation, when an operating display device is formed on the organic thin-film transistor.

The method of forming the protecting film may involve covering the organic thin-film transistor with a UV curing resin, thermosetting resin, inorganic SiONx film or the like. For effective shielding from air, the steps after fabrication of the organic thin-film transistor and before formation of the protecting film are preferably carried out without exposure to air (for example, in a dry nitrogen atmosphere or in a vacuum).

### (Surface light source and display device)

A surface light source and display device employing the organic thin-film transistor of the invention will now be described.

The surface light source and display device comprise at least two organic thin-film transistors, a driving transistor and a switching transistor. An organic thin-film transistor of the invention, as described above, is used as at least one of the organic thin-film transistors in a surface light source and display device of the invention.

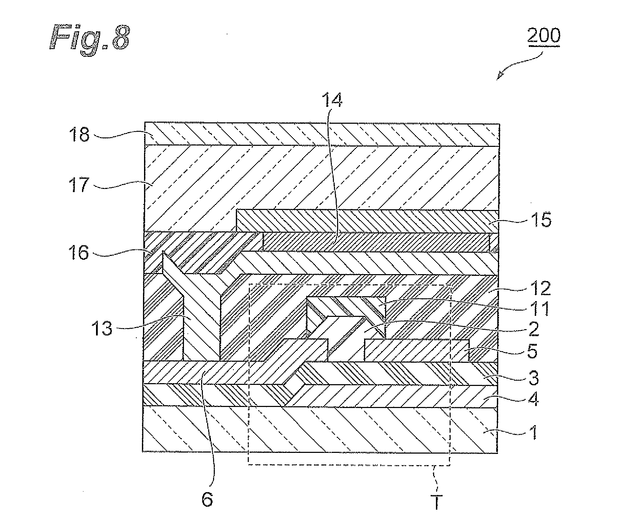

Fig. 8 is a schematic cross-sectional view of a surface light source according to a preferred embodiment. In the surface light source 200 shown in Fig. 8, an organic thin-film transistor T is constructed by a substrate 1, a gate electrode 4 formed on the substrate 1, an insulating layer 3 formed on the substrate 1 covering the gate electrode 4, a source electrode 5 and drain electrode 6 formed at a prescribed spacing on the insulating layer 3 covering portions of the region of the insulating layer 3 under which the gate electrode 4 is formed, an organic semiconductor layer 2 formed on the insulating layer 3 covering portions of the source electrode 5 and drain electrode 6, and a protective film 11 formed on the organic semiconductor layer 2 covering the entirety of the organic semiconductor layer 2.

In the surface light source 200, a lower electrode (anode) 13, a light emitting element 14 and an upper electrode (cathode) 15 are laminated in that order on the organic thin-film transistor T via an interlayer insulating film 12, and the lower electrode 13 and the drain electrode 6 are electrically connected through via holes formed in the interlayer insulating film 12. Also, a bank section 16 is provided around the lower electrode 13 and light emitting element 14. In addition, a substrate 18 is placed over the upper electrode 15, and the upper electrode 15 and substrate 18 are sealed by a sealing member 17.

In the surface light source 200 shown in Fig. 8, the organic thin-film transistor T functions as a driving transistor. The switching transistor is omitted in the surface light source 200 in Fig. 8.

In the surface light source 200 of this embodiment, an organic thin-film transistor of the invention as described above is used as the organic thin-film transistor T. Known surface light source structural members may be used as the other structural members. Transparent members are used for the upper electrode 15, sealing member 17 and substrate 18.

The surface light source 200 shown in Fig. 8 functions as a surface light source by employing a white luminescent material in the light emitting element 14, and it may be employed as a color display device by using a red luminescent material, a blue luminescent material and a green luminescent material in the light emitting element 14, and controlling the driving of each light emitting element.

Patterned luminescence in a surface light source and display device can be obtained by a method in which a mask with a patterned window is set on the front side of a planar light emitting element, a method in which sections of the luminescent layer of the light emitting element that are to be non-luminous are formed extremely thin to render them essentially non-luminous, and a method in which an anode or cathode, or both electrodes, are formed in a pattern shape. By forming a pattern by any of these methods, and configuring some electrodes to be independently ON/OFF switchable, it is possible to obtain a segment type display device allowing display of numerals, letters or simple symbols. Furthermore, for a dot matrix element, the anode and cathode may both be formed as stripes and configured in a crossing manner. A partial color display or multicolor display can also be formed by a method in which different types of polymer fluorescent materials with different luminescent colors are coated or a method using a color filter or fluorescence conversion filter. The dot matrix element may be passively driven or actively driven in combination with a TFT or the like. These display devices may be used as display devices for computers, televisions, portable terminals, cellular phones, car navigation systems, video camera viewfinders, and the like.

### Examples

The invention will now be described in greater detail by examples, with the understanding that the invention is not limited thereto.

### (Measurement of weight-average molecular weight)

The molecular weights of the polymer compounds in the following examples were measured by determining the weight-average molecular weight based on polystyrene, using a GPC by Shimadzu Corp. (trade name: LC-10Avp) or a GPC by GPC Laboratories (trade name: PL-GPC2000).

For measurement with LC-10Avp, the polymer compound was dissolved in tetrahydrofuran to a concentration of about 0.5 mass% and 50 µL thereof was injected into the GPC. The GPC mobile phase was tetrahydrofuran, and the flow rate was 0.6 mL/min. The columns used were two TSKgel SuperHM-H (Tosoh Corp.) columns and one TSKgel SuperH2000 (Tosoh Corp.) column, connected in series. The detector used was a differential refractometer (trade name: RID-10A, product of Shimadzu Corp.).

For measurement with PL-GPC2000, the polymer compound was dissolved in o-dichlorobenzene to a concentration of about 1 mass%. The GPC mobile phase was o-dichlorobenzene, and the flow rate was 1 mL/min at a measuring temperature of 140°C. The columns were three PLGEL 10 µm MIXED-B (PL Laboratories, Inc.) columns, connected in series.

### <Synthesis Example 1: Synthesis of polymer compound (1)>

In a 50 mL three-necked flask there were placed 4,4'-didodecyl-5,5'-bis(4,4,5,5-tetramethyl-1,3,5-dioxaborolan-2-yl)-2,2'-bithiophene (319 mg, 0.4 mmol), 2,6-dibromonaphtho[1,8-bc:5,4-b'c']dithiophene (149 mg, 0.4 mmol), tris(dibenzylideneacetone)dipalladium(0) (7.3 mg, 0.008 mmol), tritertiary butylphosphonium tetrafluoroborate (9.3 mg, 0.032 mmol) and tetrahydrofuran (7.7 mL). A 2 mol/L potassium carbonate aqueous solution (0.6 mL) was added thereto, reaction was conducted at 40°C for 2 hours, and the mixture was subsequently stirred with circulation for 5 hours.

Following the reaction, chlorobenzene and water were added to the solution, the mixture was stirred at 120°C for 15 minutes, and the aqueous layer was removed off. Water was then added once more, the mixture was stirred at 120°C for 15 minutes, and the aqueous layer was removed off. The obtained chlorobenzene solution was concentrated, the solution was poured into methanol, and the deposited precipitate was filtered out to obtain polymer compound (1) represented by the following formula (8) (200 mg). The weight-average molecular weight of polymer compound (1) based on polystyrene was 3.1 × 10⁴.

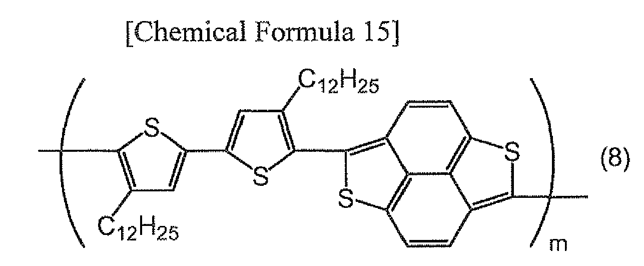

In the formula, m represents the polymerization degree.

### [Example 1]

### (Fabrication of organic thin-film transistor)

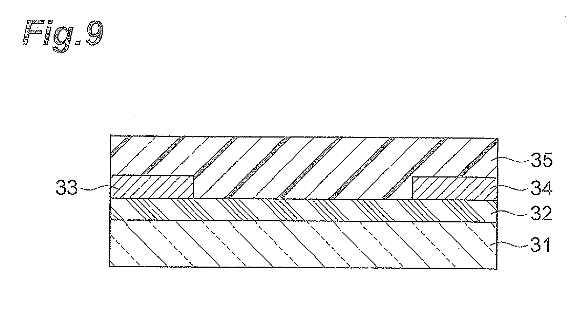

The polymer compound (1) obtained in Synthesis Example 1 was used to fabricate an organic thin-film transistor having the structure shown in Fig. 9, by the following method. First, the surface of an n-type silicon board 31 doped to a high concentration, as a gate electrode, was thermally oxidized to form a 200 nm silicon oxide film 32. Next, a source electrode 33 and drain electrode 34 with a channel length of 20 µm and a channel width of 2 mm were formed on a silicon oxide film 32 (chromium, gold from the silicon oxide film side) by photolithography. The board obtained in this manner was thoroughly washed and then hexamethylenedisilazane (HMDS) was used for silane treatment of the board surface by spin coating. Next, polymer compound (1) obtained in Synthesis Example 1 was dissolved in orthodichlorobenzene to prepare a 0.5 mass% solution, and after filtering with a membrane filter, the solution was coated onto the surface treated board by spin coating. This formed an organic semiconductor layer 35 with a thickness of about 30 nm, comprising polymer compound (1), to obtain an organic thin-film transistor.

### (Measurement of transistor properties)

The transistor properties of the fabricated organic thin-film transistor were measured under conditions with the gate voltage Vg varied between 40 to -40 V and the source/drain voltage Vsd varied between 0 to -40 V. As a result, the drain current was 0.04 µA at Vg = -40 V, Vsd = -40 V as the transfer characteristic. From this property, the field-effect mobility was calculated to be 8 × 10⁻⁴ cm²/Vs.

### <Synthesis Example 2: Synthesis of polymer compound (2)>

In a 50 mL three-necked flask there were placed 4,4'-didodecyl-5,5'-bis(4,4,5,5-tetramethyl-1,3,5-dioxaborolan-2-yl)-2,2'-bithiophene (341 mg, 0.452 mmol), 2,7-dibromo-4,5-diheptylbenzo[2,1-b:3,4-b']dithiophene (246 mg, 0.452 mmol), tris(dibenzylideneacetone)dipalladium(0) (8.3 mg, 0.009 mmol), tritertiary butylphosphonium tetrafluoroborate (10.5 mg, 0.036 mmol) and tetrahydrofuran (12 mL). The solution was heated to 60°C, a 2 mol/L potassium carbonate aqueous solution (0.7 mL) was added, and the mixture was stirred with circulation for 3 hours. After then adding phenylboronic acid (9 mg) and tetrahydrofuran (3 mL), the mixture was further stirred with circulation for 4.5 hours. Next, sodium N,N-diethyldithiocarbamate trihydrate (0.25 g) and water (6 mL) were added and the mixture was stirred for 12 hours with circulation.

Following the reaction, toluene was added to the solution and the mixture was washed with hot water, aqueous acetic acid and hot water in that order. The toluene solution was then passed through a silica gel column and an alumina column. Next, the toluene solution was concentrated, the solution was poured into methanol and the deposited precipitate was filtered out to obtain polymer compound (2) represented by the following formula (9) (302 mg). The weight-average molecular weight of polymer compound (2) based on polystyrene was 4.3 × 10⁴.

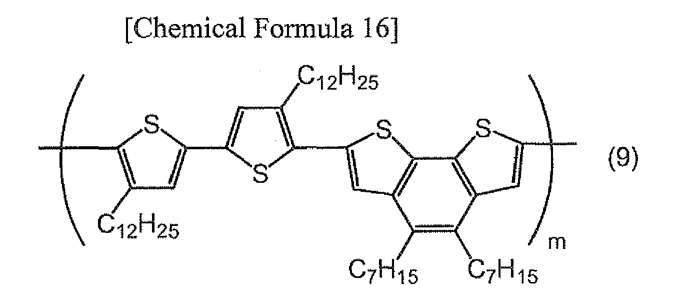

In the formula, m represents the polymerization degree.

### [Comparative Example 1]

### (Fabrication of organic thin-film transistor)

Polymer compound (2) obtained in Synthesis Example 2 was dissolved in toluene to prepare a 0.5 mass% solution. An organic thin-film transistor was fabricated in the same manner as Example 1, except that this solution was used to form the organic semiconductor layer 35.

### (Measurement of transistor properties)

The transistor properties of the fabricated organic thin-film transistor were measured under conditions with the gate voltage Vg varied between 40 to -40 V and the source/drain voltage Vsd varied between 0 to -40 V. As a result, the drain current value was 0.002 µA at Vg = - 40 V, Vsd = -40 V as the transfer characteristic, which was lower compared to Example 1. Also, the field-effect mobility was calculated to be 1 × 10⁻⁵ cm²/Vs, which was lower compared to Example 1.

### Industrial Applicability

As explained above, it is possible, by using a polymer compound having a specific structure according to the invention, to provide an organic thin-film transistor that allows excellent field-effect mobility to be obtained. Also, according to the invention, it is possible to provide a surface light source and display device comprising the organic thin-film transistor. The organic thin-film transistor of the invention is useful, for example, in a driving circuit of a liquid crystal display or electronic paper, in a switching circuit curved or flat light source used for illumination, in a segment type display device, or in a driving circuit for a dot matrix flat panel display.

### Explanation of Symbols

1: Substrate, 2: organic semiconductor layer, 2a: organic semiconductor layer, 3: insulating layer, 4: gate electrode, 5: source electrode, 6: drain electrode, 7a: first electrode, 7b: second electrode, 8: charge generation layer, 11: protective film, 12: interlayer insulating film, 13: lower electrode (anode), 14: light emitting element, 15: upper electrode (cathode), 16: bank section, 17: sealing member, 18: substrate, 100: organic thin-film transistor of first embodiment, 110: organic thin-film transistor of second embodiment, 120: organic thin-film transistor of third embodiment, 130: organic thin-film transistor of fourth embodiment, 140: organic thin-film transistor of fifth embodiment, 150: organic thin-film transistor of sixth embodiment, 160: organic thin-film transistor of seventh embodiment, 200: surface light source of embodiment.

## Claims

1. An organic thin-film transistor comprising an organic semiconductor layer containing a polymer compound having a repeating unit represented by the following formula (1) and/or a repeating unit represented by the following formula (2), and a repeating unit represented by the following formula (3): 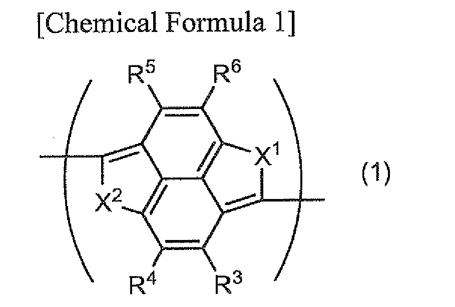 in formula (1), X¹ and X² are the same or different and each represents a chalcogen atom, and R³, R⁴, R⁵ and R⁶ are the same or different and each represents hydrogen atom, alkyl, alkoxy, alkylthio, optionally substituted aryl, aryloxy, arylthio, arylalkyl, arylalkoxy, arylalkylthio, substituted silyl, substituted carboxyl, an optionally substituted monovalent heterocyclic group, cyano or fluorine atom; 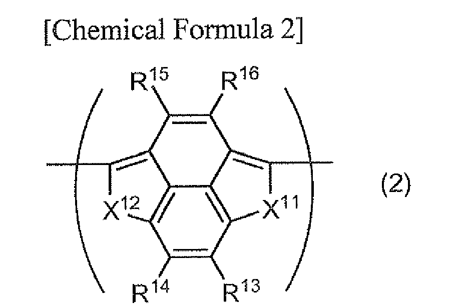 in formula (2), X¹¹ and X¹² are the same or different and each represents a chalcogen atom, and R¹³, R¹⁴, R¹⁵ and R¹⁶ are the same or different and each represents hydrogen atom, alkyl, alkoxy, alkylthio, optionally substituted aryl, aryloxy, arylthio, arylalkyl, arylalkoxy, arylalkylthio, substituted silyl, substituted carboxyl, an optionally substituted monovalent heterocyclic group, cyano or fluorine atom; 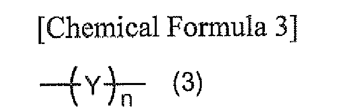 in formula (3), Y represents an arylene group comprising 3 or more fused aromatic rings that may be optionally substituted, an optionally substituted divalent heterocyclic group, an optionally substituted divalent group with a metal complex structure, or the group -C≡C-, and n represents an integer of 1-5; when there are a plurality of Y groups, the Y groups may be the same or different.

2. The organic thin-film transistor according to claim 1, wherein at least one pair of R³ and R⁵ in formula (1), R⁴ and R⁶ in formula (1), R¹³ and R¹⁵ in formula (2), and R¹⁴ and R¹⁶ in formula (2), are the same groups.

3. The organic thin-film transistor according to claim 1, wherein R³-R⁶ in formula (1) are hydrogen atoms and/or R¹³-R¹⁶ in formula (2) are hydrogen atoms.

4. The organic thin-film transistor according to any one of claims 1 to 3, wherein at least one of X¹ and X² in formula (1), and X¹¹ and X¹² in formula (2), is a sulfur atom.

5. The organic thin-film transistor according to any one of claims 1 to 4, wherein Y in formula (3) is an optionally substituted divalent heterocyclic group.

6. The organic thin-film transistor according to any one of claims 1 to 5, wherein the repeating unit represented by formula (3) is a repeating unit represented by the following formula (4): 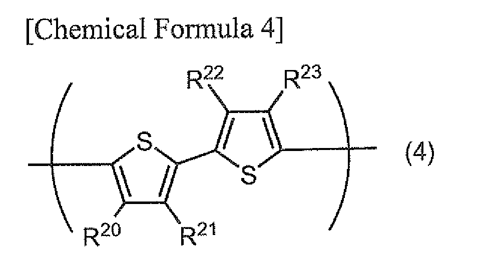 in formula (4), R²⁰, R²¹, R²² and R²³ are the same or different and each represents hydrogen atom, alkyl, alkoxy, alkylthio, optionally substituted aryl, aryloxy, arylalkyl, arylalkoxy, substituted silyl, carboxyl, an optionally substituted monovalent heterocyclic group, cyano or fluorine atom.

7. The organic thin-film transistor according to claim 6, wherein at least one of R²⁰, R²¹, R²² and R²³ in formula (4) is a C6-20 alkyl group.

8. A surface light source comprising an organic thin-film transistor according to any one of claims 1 to 7.

9. A display device comprising an organic thin-film transistor according to any one of claims 1 to 7.
